(19) **Europäisches Patentamt**
**European Patent Office**
**Office européen des brevets**

(11) **EP 1 811 663 B1**

(12) **EUROPEAN PATENT SPECIFICATION**

(45) Date of publication and mention
of the grant of the patent:
**14.09.2011 Bulletin 2011/37**

(51) Int Cl.:
***H03H 17/06*** *(2006.01)*

(21) Application number: **06001452.9**

(22) Date of filing: **24.01.2006**

(54) **Sampling rate conversion**

Abtastratenumsetzung

Conversion du taux d'échantillonnage

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**25.07.2007 Bulletin 2007/30**

(73) Proprietor: **Harman Becker Automotive Systems GmbH**
**76307 Karlsbad (DE)**

(72) Inventors:
• **Schmidt, Gerhard**
**89081 Ulm (DE)**
• **Krini, Mohamed**
**89077 Ulm (DE)**
• **Rössler, Martin**
**89077 Ulm (DE)**

(74) Representative: **Grünecker, Kinkeldey, Stockmair & Schwanhäusser Anwaltssozietät**
**Leopoldstrasse 4**
**80802 München (DE)**

(56) References cited:
**EP-A- 0 977 360      EP-A- 1 569 335**
**US-B1- 6 711 214**

**Description**

**Field of Invention**

The present invention relates to the processing of band-limited signals and is particularly concerned with the conversion of electrical signals sampled with a first sampling rate to electrical signals with a second sampling rate that is different from the first sampling rate. More particular, the invention relates to the sampling rate conversion in the case of a temporarily varying destination sampling rate.

**Prior Art**

The conversion of sampling rates is a major problem in signal processing. When two electrical devices communicate by the exchange of electrical signals usually the problem arises that the sampling rate of the one device is different from the sampling rate of the other one. For example, a first device may detect signals with a first sampling rate and process these signals. After processing, these signals are output to a second device. The second device may be intended to process the input signals coming from the first device and to output them with a sampling rate higher than the sampling rate of the first device. In this case some up-sampling must be carried out by the second device. One example of such a communication is the exchange of signals between a cellular phone and a hands-free set via the Bluetooth technology.

Another example for the need for some up-sampling of electrical signals is given by the extension of band-limited signals in the context of telephony. The common telephone band-limited audio and, in particular, speech signals exhibit a bandwidth of only 300 Hz to 3.4 kHz. Since the removal of portions of live signals with lower and higher frequencies causes degradation in speech quality, in particular, a reduced intelligibility, it is highly desirable to extend the limited bandwidth to a wider bandwidth. Some preprocessing, as increasing the sampling rate by interpolation, must usually be performed before analyzing the band limited signal in order to generate an extended less artificial signal.

The increase of a given sampling rate, i.e. the number of individual samples taken per unit time from a continuous signal to generate a discrete signal, requires the interpolation of the signal between the discrete time samples. Well-known interpolation methods include Lagrange interpolation, which is the classical technique of finding an order n polynomial which passes through n+1 given data points. Another technique known as Cubic Splines fits a third order polynomial through two points so as to achieve a certain slope at one of the data points.

US 6,711,214 B1 discloses a reduced bandwidth transmitter including a vestigial sideband modulator for transferring energy in a portion of a spectrum on a first side of a predetermined frequency to a second side of the predetermined frequency. At the low band edge of the spectrum, the predetermined frequency is the pilot carrier frequency. At the high end of the spectrum, the predetermined frequency is the Nyquist sampling frequency. The energy is transferred on a frequency to frequency basis as a function of the energy in the RRC transition and the amplitude of a weighting function extending between the intermediate frequency and the predetermined frequency.

EP 1 569 335 A discloses a method for implementing a fractional sampled rate converter wherein aliasing is suppressed by appropriate weighting of a provisional data stream.

In particular, in the context of sampling rate conversion with a temporarily varying destination sampling rate, the following two methods have been employed in the past. According to the first method, a highly over-sampled signal is generated from an input signal. For each destination discrete sample, the closest artificially generated time sample is chosen. The half of the over-sampling rate represents the maximum error. Obviously, the higher the over-sampling rate is chosen the lower the corresponding error is. This brute force method, however, requires a high computing and memory capacitance.

The second method represents a quasi-continuous interpolation of individual samples x(n) of a continuous absolutely integrable signal x(t), where t is time in seconds and n ranges over integers. According to this method, the sine cardinal function is employed in order to generate a signal value at the desired sampling time $T_a$:

$$x(T_a) = \sum_{n=-\infty}^{\infty} x(n) h_s(T_a - nT_{in}), \tag{1}$$

with

$$h_s(t) = \mathrm{sinc}(f_{in}t) := \frac{\sin(\pi f_{in} t)}{\pi f_{in} t}. \tag{2}$$

In these equations $T_{in}$ and $f_{in}$ represent the original (input) sampling time (period) and sampling rate ($f_{in}$ = 1 / $T_{in}$), respectively.

If the destination sampling rate is less than the original sampling rate, a low pass cut-off must be placed below half of the new lower sampling rate in order to avoid aliasing.

Whereas the sinc-interpolation guarantees a relatively high quality for an arbitrary choice of the destination sampling rate, it also requires a huge amount of computing time. For a detailed interpolation of the sinc-function, high memory resources are required. Moreover, in practice the quality of the reproduction signal is limited by the necessity of a finite summation in equation 1.

It is therefore, the problem underlying the present invention to overcome the above-mentioned drawbacks and to provide a method for the conversion of sampling rates with a smaller requirement for computer resources as compared to the art.

**Description of the Invention**

The above-mentioned problem is solved by a method according to claim 1. The inventive method for processing an input signal of a first sampling rate comprises the steps of

up-sampling the input signal to obtain an up-sampled signal;

low-pass filtering the up-sampled signal to obtain a first filtered up-sampled signal;

time-delaying the up-sampled signal and subsequently low-pass filtering the time-delayed up-sampled signal to obtain a second filtered up-sampled signal;

weighting the first filtered up-sampled signal by a first weight factor to obtain a first weighted signal;

weighting the second filtered up-sampled signal by a second weight factor different from the first weight factor to obtain a second weighted signal; and

adding the first weighted signal and the second weighted signal to obtain a first output signal of a second sampling rate different from the first sampling rate.

The input signal of a first sampling rate may be a digital signal sampled from an analogous signal with a predetermined sampling rate, i.e. number of individual samples per time taken from a continuous signal to generate the discrete digital signal. The input signal may comprise more or less sampling instants and, thus, individual samples, per band interval than the first output signal.

The inventive method only requires for relatively small computer resources, in particular, memory. Therefore, the method is very practical for hardware implementation. Basically, it comprises just one convolution of low order and a few addition operations.

Low-pass filtering of both the up-sampled and the time-delayed up-sampled signals are preferably carried out by means of a Finite Impulse Response (FIR) filter in order to delete aliasing components that otherwise might occur.

The low-pass filtering of the time-delayed up-sampled signal can be performed using the same impulse response as for the low-pass filtering of the up-sampled signal, but delayed according to the time-delay of the signal. Advantageously, the time delaying step results in a time delay of one sampling instant (one discrete sample). In this case, low-pass filtering of the time-delayed up-sampled signal is carried out by the impulse response used for filtering the non-delayed signal but delayed by one sampling instant.

The first and second weight factors may be time-dependent. The value of the second weight factor may be given by 1 - the value of the first weight factor. Thus, with $y_L(n)$ and $y_L(n-1)$ denoting the first and second filtered up-sampled signal, respectively, and $a(n)$ denoting the first weight factor the first output signal $v_L(n)$ is obtained by $v_L(n) = a(n)\, y_L(n) + (1 - a(n))\, y_L(n-1)$.

The low-pass filtering can very effectively be carried out when the up-sampled signal is obtained by inserting L - 1 nulls between the individual samples for the respective sampling instants of the input signal of the first sampling rate (i.e., inserting nulls, if $\mathrm{mod}(n, L) \neq 0$, where n ranges over integers and represents a discrete time index, i.e. sampling instant), where L is the factor by which the first signal is up-sampled, and a modified convolution of the input signal with the impulse response of the low-pass FIR filter $h_{TP,i}$ according to

$$y_L(n) = \sum_{k=0}^{\left\lceil \frac{N}{L} \right\rceil} x\left(\lfloor n/L \rfloor - k\right) h_{TP,kL+\mathrm{mod}(n,L)} \cdot \qquad (3)$$

In equation 3 the parameter N denotes the length (number of filter coefficients) of the low-pass filter.

In this case, the first output signal of the second sampling rate can be obtained by means of time-dependent filter coefficients $\mathbf{h}_{TP}(n)$ used for the low-pass filtering according to

$$v_L(n) = a(n) y_L(n) + (1 - a(n)) y_L(n-1) = \mathbf{x}^T(n) \mathbf{h}_{TP}(n) \qquad , \qquad (4)$$

where the upper index T indicates the transposition operation, and with

$$\mathbf{x}(n) = \begin{bmatrix} x(\lfloor n/L \rfloor) \\ x(\lfloor n/L \rfloor - 1) \\ \cdots \\ x(\lfloor n/L \rfloor - \lceil N/L \rceil) \end{bmatrix} \qquad (5)$$

and

$$\mathbf{h}_{TP}(n) = a(n) \begin{bmatrix} h_{TP,\mathrm{mod}(n,L)} \\ h_{TP,L+\mathrm{mod}(n,L)} \\ \cdots \\ h_{TP,L\lceil N/L \rceil + \mathrm{mod}(n,L)} \end{bmatrix} + (1 - a(n)) \begin{bmatrix} h_{TP,\mathrm{mod}(n,L)-1} \\ h_{TP,L+\mathrm{mod}(n,L)-1} \\ \cdots \\ h_{TP,L\lceil N/L \rceil + \mathrm{mod}(n,L)-1} \end{bmatrix} \cdot \qquad (6)$$

Usually, if some up-sampling of an input signal is desired, the first output signal after up-sampling exhibits a sampling rate above the eventually desired one. Therefore, the first output signal ($v_L(n)$) of the second sampling rate can be down-sampled to obtain a second (destination) output signal ($v(n)$) of a third sampling rate that is different from the second sampling rate and usually also different from the first sampling rate.

In this case, the first weight factor can be obtained by

$$a(n) = 1 - \left( \left\lceil n \frac{f_{in}}{f_{out}} L \right\rceil - n \frac{f_{in}}{f_{out}} L + f_0 \delta_K(n) \right) \qquad (7)$$

with $f_0$ defined as

$$f_0 = \left( \left\lceil \frac{f_{in}}{f_{out}} L \right\rceil - \frac{f_{in}}{f_{out}} L \right), \qquad (8)$$

where $\delta_K$ is the Kronecker-Delta function and L is the factor by which the input (original) signal of the first (original) sampling rate $f_{in}$ is up-sampled to the third sampling rate $f_{out}$ of the second (destination) output signal. The symbols $\lceil \rceil$ and $\lfloor \rfloor$ denote rounding to the closest larger or smaller integer, respectively.

The above-described aspects of the inventive method can also be modified in order to be useful for a time-dependent third sampling rate to which the input signal is to be converted. When the third sampling rate is time-dependent, the input signal of the first sampling rate can be stored in a first buffer, in particular, a first ring buffer, and/or the second output signal of the third sampling rate can be stored in a second buffer, in particular, a second ring buffer. By monitoring the respective write and read pointers it can be determined, whether one of the buffers becomes empty or is close to an overflow state. In these cases, the third sampling rate can be corrected in order to guarantee faultless processing of the input signal.

The time-dependent third sampling rate may comprise a constant nominal value as well as a time-dependent correction term $\Delta f_{out}(n)$ that can be adjusted according to

$$\Delta f_{out}(n) = \begin{cases} \min\{\Delta f_{out}(n-1)+\Delta, \Delta f_{out,\max}\}, \text{if content of second buffer} \\ \qquad\qquad\qquad \text{is below a first predetermined} \\ \qquad\qquad\qquad \text{threshold} \\ \\ \max\{\Delta f_{out}(n-1)-\Delta, \Delta f_{out,\min}\}, \text{if content of second buffer} \\ \qquad\qquad\qquad \text{is above a second predetermined} \\ \qquad\qquad\qquad \text{threshold} \\ \\ \Delta f_{out}(n-1), \text{else} \end{cases}$$

$$(9)$$

where $\Delta$ is the maximum change of the sampling rate from one sampling instant to the subsequent sampling instant.

Employing the correction term $\Delta f_{out}(n)$ given in equation 9, the second output signal v(n) of the third sampling rate can be obtained by

$$v(n) = \left(1 - \left\lceil \sum_{i=0}^{n} \frac{f_{in}}{f_{out}(i)} L \right\rceil + \sum_{i=0}^{n} \frac{f_{in}}{f_{out}(i)} L - f_0 \delta_K(n) \right) y_L\left(\sum_{m=0}^{n} R(m)\right)$$
$$+ \left(\left\lceil \sum_{i=0}^{n} \frac{f_{in}}{f_{out}(i)} L \right\rceil - \sum_{i=0}^{n} \frac{f_{in}}{f_{out}(i)} L + f_0 \delta_K(n) \right) y_L\left(\sum_{m=0}^{n} R(m) - 1\right)$$

$$(10)$$

with the down-sampling factor

$$R(n) = \left\lceil \sum_{i=0}^{n} \frac{f_{in}}{f_{out}(i)} L \right\rceil - \sum_{m=0}^{n-1} R(m) + \left\lceil \frac{f_{in}}{f_{out}} L \right\rceil \delta_K(n).$$

$$(11)$$

Embodiments of the inventive methods that are useful for sampling rate conversion in the case of a time-dependent third (destination) sampling rate can also be employed in cases in which the first (original) sampling rate is time-dependent.

The present invention also provides a signal processing means configured to generate from an input signal of a first sampling rate a first output signal of a second sampling rate different from the first sampling rate and/or configured to generate from an input signal of a first sampling rate a second output signal of a third sampling rate different from the first sampling rate and/or different from the second sampling rate by carrying out processing steps according to one of the above-discussed examples of the inventive method.

Moreover, an electrical device is provided that is configured to send signals to and/or receive signals from another electrical device, comprising the signal processing means mentioned above. Examples for the electrical device are cellular phones, headsets, and hands-free sets.

Furthermore, the present invention provides a computer program product comprising one or more computer readable media having computer executable instructions for performing the steps of embodiments of the inventive method for sampling rate conversion as described above.

Additional features and advantages of the present invention will be described with reference to the drawings. In the following description, reference is made to the accompanying figures that are meant to illustrate preferred embodiments of the invention. It is understood that such embodiments do not represent the full scope of the invention that is defined by the claims given below.

Fig. 1 is a block diagram illustrating the principles of an example of the method for sampling rate conversion according to the present invention including low-pass filtering of an up-sampled original signal and a time-delayed up-sampled original signal and weighting of the low-pass filtered signals.

Fig. 2 illustrates the original signal, time-dependent weighting, time-dependent sampling rate decimation and the destination signal.

Fig. 3 illustrates an example for the sampling rate conversion according to the present invention for the case of a time-dependent destination sampling rate. This example employs buffering of the original as well as the destination signal.

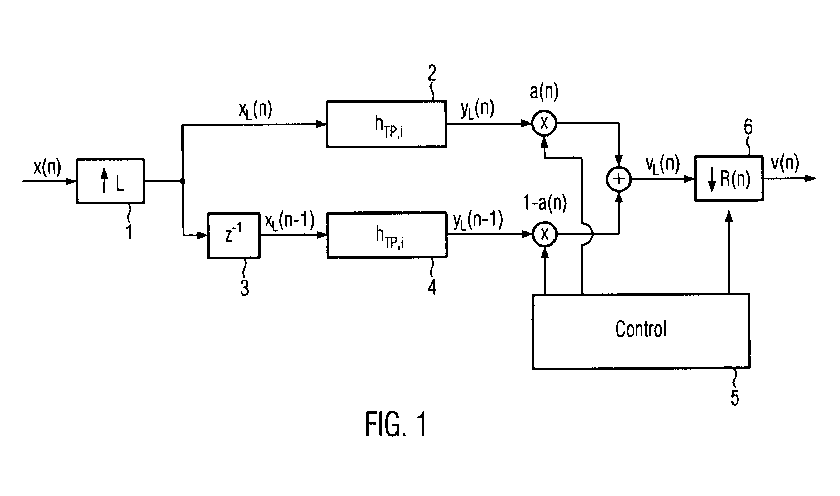

Fig. 1 illustrates an example of the inventive method of sampling rate conversion to obtain an output signal v (n), where n denotes the discrete time index, of a destination (output) sampling rate $f_{out}$ from an input signal x(n) of an original (input) sampling rate $f_{in}$. First, the input signal x(n) is up-sampled 1 to a sampling rate $f_{up} > f_{in}$ by a factor of L, L being an integer, i.e. $f_{up} = L f_{in}$. The up-sampled signal $x_L(n)$ is obtained by inserting L - 1 nulls between the samples of the original signal, i.e. $x_L(n) = x(n/L)$, if mod (n, L) = 0 , mod being the modulo function, and $x_L(n) = 0$, else.

On the one hand, $x_L(n)$ is subject to a convolution 2 with an impulse response of a low-pass filter with coefficients $h_{TP,i}$ in one processing branch

$$y_L(n) = \sum_{i=-\infty}^{\infty} x_L(n-i) h_{TP,i} \; .$$

On the other hand, $x_L(n)$ is time-delayed 3 by one sampling instant in another processing branch and the time-delayed signal is subsequently subject to a convolution 4 with the impulse response comprising the same filter vector as employed in the first processing branch but delayed by one sampling instant. In order to prevent aliasing, an FIR filter is used for the low-pass filtering process.

Further, since $x_L(n)$ has been generated by inserting nulls, the filtered non-delayed up-sampled signal $y_L(n)$ can be obtained by

$$y_L(n) = \sum_{k=0}^{\left\lceil \frac{N}{L} \right\rceil} x_L\big(n - kL - \mathrm{mod}(n, L)\big) h_{TP, kL + \mathrm{mod}(n, L)}$$

and since $x_L(n)$ is only used for non-vanishing values

$$y_L(n) = \sum_{k=0}^{\left\lceil \frac{N}{L} \right\rceil} x\left( \lfloor n/L \rfloor - k \right) h_{TP,kL+\mathrm{mod}(n,L)} \; ,$$

where the symbols $\lceil \; \rceil$ and $\lfloor \; \rfloor$ denote rounding to the closest larger or smaller integer, respectively.

A control means 5 provides time-dependent factors a(n) and 1 - a(n) for the first and second processing branch, respectively, to obtain the output signal $v_L(n)$ of a sampling rate much higher than the one of the input signal by the weighted sum of $y_L(n)$ and $y_L(n-1)$:

$$v_L(n) = a(n)y_L(n) + (1-a(n))y_L(n-1) \; .$$

The weighting and convolution processes can be carried out by

$$v_L(n) = \mathbf{x}^T(n)\mathbf{h}_{TP}(n)$$

by means of the signal vector

$$\mathbf{x}(n) = \begin{bmatrix} x(\lfloor n/L \rfloor) \\ x(\lfloor n/L \rfloor - 1) \\ \cdots \\ x(\lfloor n/L \rfloor - \lceil N/L \rceil) \end{bmatrix}$$

and the time-dependent filter vector of the used low-pass filter

$$\mathbf{h}_{TP}(n) = a(n) \begin{bmatrix} h_{TP,\mathrm{mod}(n,L)} \\ h_{TP,L+\mathrm{mod}(n,L)} \\ \cdots \\ h_{TP,L\lceil N/L \rceil + \mathrm{mod}(n,L)} \end{bmatrix} + (1-a(n)) \begin{bmatrix} h_{TP,\mathrm{mod}(n,L)-1} \\ h_{TP,L+\mathrm{mod}(n,L)-1} \\ \cdots \\ h_{TP,L\lceil N/L \rceil + \mathrm{mod}(n,L)-1} \end{bmatrix} .$$

By an appropriate choice of a(n) by the processing means 5, in principle, the signal value for each arbitrary sampling instant, i.e. the discrete time point at which an individual sample of a signal is taken, can be calculated at least approximately.

The sampling rate $f_{up}$ of the output signal $v_L(n)$ is usually higher than a desired sampling rate $f_{out}$ and, thus, $v_L(n)$ must be down-sampled. In particular, by an appropriate choice of a(n) and the parameters of a down-sampling factor R(n) it can be ensured that each sampling instant of the original signal exactly corresponds to one sampling instant of a desired sampling rate as follows:

$$R(n) = \left\lceil n \frac{f_{in}}{f_{out}} L \right\rceil - \sum_{m=0}^{n-1} R(m) + \left\lceil n \frac{f_{in}}{f_{out}} L \right\rceil \delta_K(n)$$

and

$$a(n) = 1 - \left( \left\lceil n \frac{f_{in}}{f_{out}} L \right\rceil - n \frac{f_{in}}{f_{out}} L + f_0 \delta_K(n) \right)$$

with the Kronecker-Delta function $\delta_K$ and where $f_0$ is defined as

$$f_0 = \left( \left\lceil \frac{f_{in}}{f_{out}} L \right\rceil - \frac{f_{in}}{f_{out}} L \right).$$

Thus, the desired output signal v(n) with a sampling rate higher than the input signal x(n) but lower than the sampling rate of $v_L(n)$ is eventually obtained as

$$v(n) = \left( 1 - \left\lceil n \frac{f_{in}}{f_{out}} L \right\rceil + n \frac{f_{in}}{f_{out}} L - f_0 \delta_K(n) \right) y_L \sum_{m=0}^{n} R(m)$$

$$+ \left( \left\lceil n \frac{f_{in}}{f_{out}} L \right\rceil - n \frac{f_{in}}{f_{out}} L + f_0 \delta_K(n) \right) y_L \left( \sum_{m=0}^{n} R(m) - 1 \right).$$

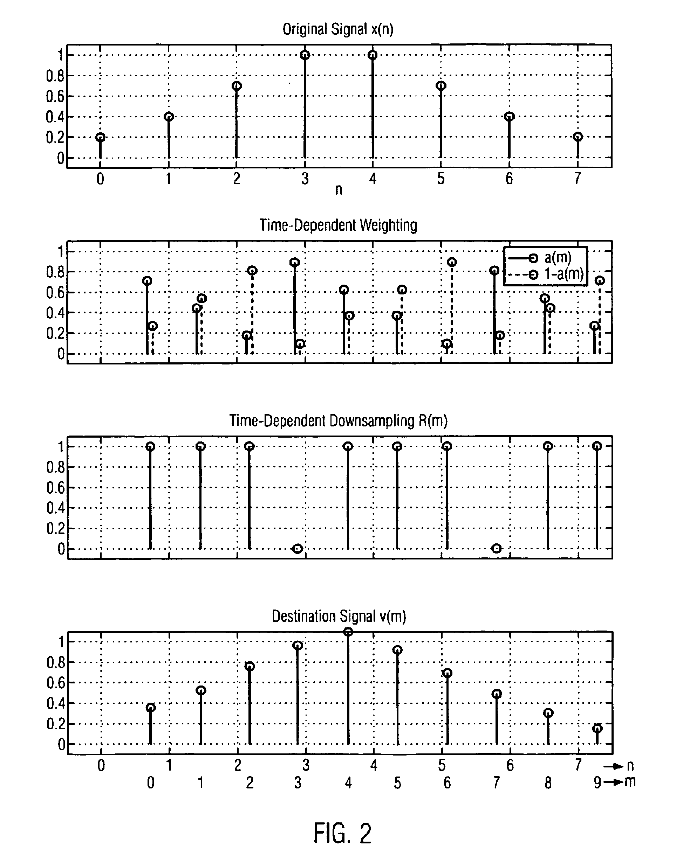

Fig. 2 shows an example of a sampling rate conversion of a signal with an original sampling rate of 8 kHz as indicated by the integer n (upper row) to a destination signal of a sampling rate of 11,025 kHz as indicated by the integer m (lower row). Eight sampling instants (n = 0 .. 7) are shown for the original signal x(n) corresponding to ten sampling instants (m = 0 .. 9) in a comparable band interval. The original signal is converted by means of the weighting factors a (m) and 1 - a(m) (second row) and the time-dependent down-sampling R(m). The factor for the up-sampling is set to L = 1 for an easier understanding and for a better intelligibility of the second row the weighting factors are slightly shifted with respect to each other.

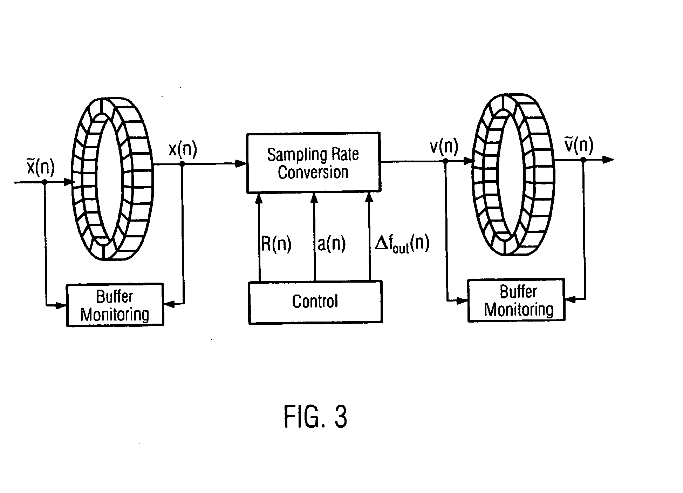

Fig. 3 shows another example for the inventive method of sampling rate conversion wherein the destination sampling rate is time-dependent. As shown in Fig. 3 the original (input) signal $\tilde{x}(n)$ and the destination (output) signal v(n) are buffered in a ring buffer. Alternatively, only one of the original signal and the destination signal is input in a buffer. By monitoring the write/read pointers it can be determined whether one of the buffers becomes empty or runs the risk of an overflow. Correction of the destination sampling rate in order to avoid an empty or overflow state of one of the buffers can be performed as follows. The destination rate $f_{out}$ is split in a constant part $\bar{f}_{out}$ and a time-varying correction $\Delta f_{out}(n) : f_{out} = \bar{f}_{out} + \Delta f_{out}(n)$ where

$$\Delta f_{out}(n) = \begin{cases} \min\{\Delta f_{out}(n-1)+\Delta, \Delta f_{out,\max}\}, \text{if content of second buffer} \\ \qquad\qquad\qquad\qquad\text{is below a first predetermined} \\ \qquad\qquad\qquad\qquad\text{threshold} \\ \\ \max\{\Delta f_{out}(n-1)-\Delta, \Delta f_{out,\min}\}, \text{if content of second buffer} \\ \qquad\qquad\qquad\qquad\text{is above a second predetermined} \\ \qquad\qquad\qquad\qquad\text{threshold} \\ \\ \Delta f_{out}(n-1), \text{else} \end{cases}$$

and $\Delta$ is the maximum change of the sampling rate from one sampling instant to the subsequent sampling instant and may, e.g., be in the range of $10^{-7}$ to 0.01 Hz.

Using the time-dependent destination sampling rate including the correction term $\Delta f_{out}(n)$ the calculations described with reference to Fig. 1 are performed to obtain the

$$v(n) = \left(1 - \left[\sum_{i=0}^{n}\frac{f_{in}}{f_{out}(i)}L\right] + \sum_{i=0}^{n}\frac{f_{in}}{f_{out}(i)}L - f_0\delta_K(n)\right)y_L\left(\sum_{m=0}^{n}R(m)\right)$$
$$+ \left(\left[\sum_{i=0}^{n}\frac{f_{in}}{f_{out}(i)}L\right] - \sum_{i=0}^{n}\frac{f_{in}}{f_{out}(i)}L + f_0\delta_K(n)\right)y_L\left(\sum_{m=0}^{n}R(m)-1\right)$$

with the down-sampling factor

$$R(n) = \left[\sum_{i=0}^{n}\frac{f_{in}}{f_{out}(i)}L\right] - \sum_{m=0}^{n-1}R(m) + \left[\frac{f_{in}}{f_{out}}L\right]\delta_K(n).$$

In addition, the above-described signal processing may also be performed for a time-varying input sampling rate with which the digital input signal x(n) might be sampled from an continuous analogous signal.

## Claims

1.  Method for processing an input signal (x(n)) of a first sampling rate, comprising the steps of
    up-sampling (1) the input signal (x(n)) to obtain an up-sampled signal ($x_L$(n));
    low-pass filtering (2) the up-sampled signal ($x_L$(n))to obtain a first filtered up-sampled signal ($y_L$(n));
    time-delaying (3) the up-sampled signal ($x_L$(n)), in particular, by one sampling instant, and subsequently low-pass filtering (4) the time-delayed up-sampled signal ($x_L$(n-1)) to obtain a second filtered up-sampled signal ($y_L$(n-1));
    weighting the first filtered up-sampled signal ($y_L$(n)) by a first weight factor to obtain a first weighted signal;
    weighting the second filtered up-sampled signal ($y_L$(n-1)) by a second weight factor different from the first weight factor to obtain a second weighted signal; and
    adding the first weighted signal and the second weighted signal to obtain a first output signal ($v_L$(n)) of a second sampling rate different from the first sampling rate.

2.  The method according to claim 1, wherein the low-pass filtering (2, 4) of both the up-sampled and the time-delayed up-sampled signals ($x_L$(n), $x_L$(n-1)) is carried out by means of a Finite Impulse Response Filter.

3. The method according to claim 1 or 2, wherein the time-delayed up-sampled signal ($x_L$(n-1)) is time-delayed by one sampling instant with respect to the non-delayed up-sampled signal ($x_L$(n)) and the low-pass filtering (4) of the time-delayed up-sampled signal ($x_L$(n-1)) is performed using the same impulse response but delayed by one sampling instant as the one used for the low-pass filtering (2) of the non-delayed up-sampled signal ($x_L$(n)).

4. The method according to one of the preceding claims, wherein the first and the second weight factors are time-dependent or constant and the value of the second weight factor is given by 1 minus the value of the first weight factor.

5. The method according to one of the claims 2-4, wherein the up-sampled signal ($x_L$(n)) is obtained by inserting L- 1 nulls between the individual samples of the input signal of the first sampling rate, where L is the factor by which the input signal (x(n)) is up-sampled, and the first filtered up-sampled signal ($y_L$(n)) is obtained by the modified convolution of the input signal (x(n)) with the impulse response ($h_{TP}$,) of the Finite Impulse Response Filter according to

$$y_L(n) = \sum_{k=0}^{\left\lceil \frac{N}{L} \right\rceil} x\left( \lfloor n/L \rfloor - k \right) h_{TP,kL+\mathrm{mod}(n,L)} \, ,$$

where L is the factor by which the input signal (x(n)) is up-sampled and N denotes the filter length of the low-pass filter.

6. The method according to claim 5, wherein the first output signal ($v_L$(n)) of the second sampling rate is obtained by means of time-dependent filter coefficients ($h_{TP}$) used for the low-pass filtering according to

$$v_L(n) = a(n) y_L(n) + (1-a(n)) y_L(n-1) = \mathbf{x}^T(n) \mathbf{h}_{TP}(n)$$

with

$$\mathbf{x}(n) = \begin{bmatrix} x(\lfloor n/L \rfloor) \\ x(\lfloor n/L \rfloor - 1) \\ \dots \\ x(\lfloor n/L \rfloor - \lceil N/L \rceil) \end{bmatrix}$$

and

$$\mathbf{h}_{TP}(n) = a(n) \begin{bmatrix} h_{TP,\mathrm{mod}(n,L)} \\ h_{TP,L+\mathrm{mod}(n,L)} \\ \dots \\ h_{TP,L\lceil N/L \rceil + \mathrm{mod}(n,L)} \end{bmatrix} + (1-a(n)) \begin{bmatrix} h_{TP,\mathrm{mod}(n,L)-1} \\ h_{TP,L+\mathrm{mod}(n,L)-1} \\ \dots \\ h_{TP,L\lceil N/L \rceil + \mathrm{mod}(n,L)-1} \end{bmatrix} ,$$

where a(n) is the first weight factor and the upper index T denotes the transposed of a vector or a matrix.

7. The method according to one of the preceding claims, wherein the first output signal ($v_L$(n)) of the second sampling rate is down-sampled (6) to obtain a second output signal (v(n)) of a third sampling rate different from the second sampling rate.

**8.** The method according to claim 7, wherein the first weight factor is given by

$$a(n) = 1 - \left( \left\lceil n \frac{f_{in}}{f_{out}} L \right\rceil - n \frac{f_{in}}{f_{out}} L + f_0 \delta_K(n) \right)$$

with $f_0$ defined as

$$f_0 = \left( \left\lceil \frac{f_{in}}{f_{out}} L \right\rceil - \frac{f_{in}}{f_{out}} L \right),$$

where $\delta_K$ is the Kronecker-Delta function, L is the factor by which the input signal x(n) of the first sampling rate $f_{in}$ is up-sampled, $f_{out}$ is the third sampling rate of the second output signal (v(n)), and the symbols $\lceil \rceil$ and $\lfloor \rfloor$ denote rounding to the closest larger or smaller integer, respectively.

**9.** The method according to one of the claims 7 or 8, wherein the third sampling rate is time-dependent and the input signal (x(n)) is stored in a first buffer and/or the second output signal (v(n)) is stored in a second buffer.

**10.** The method according to claim 9, wherein the third sampling rate comprises a constant contribution and a time-dependent contribution given by

$$\Delta f_{out}(n) = \begin{cases} \min\{\Delta f_{out}(n-1) + \Delta, \Delta f_{out,max}\}, & \text{if content of second buffer is below a first predetermined threshold} \\ \max\{\Delta f_{out}(n-1) - \Delta, \Delta f_{out,min}\}, & \text{if content of second buffer is above a second predetermined threshold} \\ \Delta f_{out}(n-1), & \text{else} \end{cases}$$

and the second output signal (v(n)) is obtained by

$$v(n) = \left(1 - \left\lceil \sum_{i=0}^{n} \frac{f_{in}}{f_{out}(i)} L \right\rceil + \sum_{i=0}^{n} \frac{f_{in}}{f_{out}(i)} L - f_0 \delta_K(n) \right) y_L \left( \sum_{m=0}^{n} R(m) \right)$$

$$+ \left( \left\lceil \sum_{i=0}^{n} \frac{f_{in}}{f_{out}(i)} L \right\rceil - \sum_{i=0}^{n} \frac{f_{in}}{f_{out}(i)} L + f_0 \delta_K(n) \right) y_L \left( \sum_{m=0}^{n} R(m) - 1 \right)$$

with

$$R(n) = \left\lceil \sum_{i=0}^{n} \frac{f_{in}}{f_{out}(i)} L \right\rceil - \sum_{m=0}^{n-1} R(m) + \left\lceil \frac{f_{in}}{f_{out}} L \right\rceil \delta_K(n).$$

11. The method according to one of the claims 8-10, wherein the first sampling rate is time-dependent.

12. Signal processing means, configured to generate from an input signal (x(n)) of a first sampling rate a first output signal ($v_L$(n)) of a second sampling rate that is different from the first sampling rate by carrying out processing steps according to one of the claims 1-6.

13. Signal processing means according to claim 12, configured to generate from an input signal (x(n)) of a first sampling rate a second output signal (v(n)) of a third sampling rate that is different from the first sampling rate and/or different from the second sampling rate by carrying out processing steps according to one of the claims 7 - 11.

14. Electrical device, in particular, a cellular phone or headset or hands-free set, comprising the signal processing means according to one of the claims 12 or 13.

15. Computer program product comprising one or more computer readable media having computer executable instructions for performing the steps of the methods of one of the claims 1 - 11.

## Patentansprüche

1. Verfahren zum Verarbeiten eines Eingangssignals (x(n)) mit einer ersten Abtastrate, das die Schritte umfasst
Überabtasten (1) des Eingangssignals (x(n)), um ein überabgetastetes Signal ($x_L$(n)) zu erhalten;
Tiefpassfiltern (2) des überabgetasteten Signals ($x_L$(n)), um ein erstes gefiltertes überabgetastetes Signal ($y_L$(n)) zu erhalten;
Zeitverzögern (3) des überabgetasteten Signals ($x_L$(n)), insbesondere um eine Abtasteinheit, und nachfoigendes Tiefpassfiltern (4) des zeitverzögerten überabgetasteten Signals ($x_L$(n)), um ein zweites gefiltertes überabgetastetes Signal ($y_L$(n-1)) zu erhalten;
Gewichten des ersten gefilterten überabgetasteten Signals ($y_L$(n)) mit einem ersten Gewichtsfaktor, um ein erstes gewichtetes Signal zu erhalten;
Gewichten des zweiten gefilterten überabgetasteten Signals ($y_L$(n-1)) mit einem zweiten Gewichtsfaktor, der von dem ersten Gewichtsfaktor verschieden ist, um ein zweites gewichtetes Signal zu erhalten; und
Addieren des ersten gewichteten Signals und des zweiten gewichteten Signals, um ein erstes Ausgangssignal ($v_L$(n)) mit einer zweiten Abtastrate, die von der ersten Abtastrate verschieden ist, zu erhalten.

2. Das Verfahren gemäß Anspruch 1, in dem das Tiefpassfiltern (2, 4) sowohl des überabgetasteten als auch des zeitverzögerten überabgetasteten Signals ($x_L$(n)), $x_L$(n-1)) mithilfe eines Finite-Impulse-Response-Filters ausgeführt wird.

3. Das Verfahren gemäß Anspruch 1 oder 2, in dem das zeitverzögerte überabgetastete Signal ($x_L$(n-1)) um eine Abtasteinheit bezüglich des nicht-zeitverzögerten überabgetasteten Signals ($x_L$(n)) verzögert wird, und das Tiefpassfiltern (4) des zeitverzögerten überabgetasteten Signals ($x_L$(n-1)) unter Verwendung derselben Impulsantwort, jedoch um eine Abtasteinheit verzögert, wie derjenige, die für das Tiefpassfiltern (2) des nicht-zeitverzögerten überabgetasteten Signals ($x_L$(n)) verwendet wird, ausgeführt wird.

4. Das Verfahren gemäß einem der vorhergehenden Ansprüche, in dem der erste und zweite Gewichtsfaktor zeitabhängig oder konstant sind, und der Wert des zweiten Gewichtsfaktors durch 1 minus dem Wert des ersten Gewichtsfaktors gegeben ist.

5. Das Verfahren gemäß einem der Ansprüche 2 - 4, in dem das überabgetastete Signal ($x_L$(n)) durch Einfügen von L - 1 Nullen zwischen den einzelnen Abtastwerten des Eingangssignal mit der ersten Abtastrate erhalten wird, wobei L der Faktor ist, um den das Eingangssignal (x(n)) überabgetastet wird, und das erste gefilterte überabgetastete Signal ($y_L$(n)) durch die modifizierte Faltung des Eingangssignals (x(n)) mit der Impulsantwort ($h_{TP}$) des Finite-Impulse-Response-Filters gemäß

$$y_L(n) = \sum_{k=0}^{\left\lceil \frac{N}{L} \right\rceil} x\left( \lfloor n/L \rfloor - k \right) h_{TP,kL+\mathrm{mod}(n,L)} \, ,$$

erhalten wird, wobei L der Faktor ist, um den das Eingangssignal (x(n)) überabgetastet wird, und N die Filterlänge des Tiefpassfilters bezeichnet.

6. Das Verfahren gemäß Anspruch 5, in dem das erste Ausgangssignal ($v_L$(n)) mit der zweiten Abtastrate mithilfe zeitabhängiger Filterkoeffizienten ($h_{TP}$), die für das Tiefpassfiltern verwendet werden, gemäß

$$\mathsf{V}_L(n) = a(n)y_L(n) + (1 - a(n))y_L(n-1) = \mathbf{x}^T(n)\mathbf{h}_{TP}(n)$$

mit

$$\mathbf{x}(n) = \begin{bmatrix} x(\lfloor n/L \rfloor) \\ x(\lfloor n/L \rfloor - 1) \\ ... \\ x(\lfloor n/L \rfloor - \lceil N/L \rceil) \end{bmatrix}$$

und

$$\mathbf{h}_{TP}(n) = a(n)\begin{bmatrix} h_{TP,\mathrm{mod}(n,L)} \\ h_{TP,L+\mathrm{mod}(n,L)} \\ ... \\ h_{TP,L\lceil N/L \rceil + \mathrm{mod}(n,L)} \end{bmatrix} + \left(1 - a(n)\right)\begin{bmatrix} h_{TP,\mathrm{mod}(n,L)-1} \\ h_{TP,L+\mathrm{mod}(n,L)-1} \\ ... \\ h_{TP,L\lceil N/L \rceil + \mathrm{mod}(n,L)-1} \end{bmatrix} ,$$

erhalten wird, wobei a(n) der erste Gewichtsfaktor ist und der obere Index T die Transponierte eines Vektors oder einer Matrix bezeichnet.

7. Das Verfahren gemäß einem der vorhergehenden Ansprüche, in dem das erste Ausgangssignal ($v_L$(n)) mit der zweiten Abtastrate unterabgetastet (6) wird, um ein zweites Ausgangssignal (v(n)) mit einer dritten Abtastrate, die von der zweiten Abtastrate verschieden ist, zu erhalten.

**8.** Das Verfahren gemäß Anspruch 7, in dem der erste Gewichtsfaktor durch

$$a(n) = 1 - \left( \left\lceil n \frac{f_{in}}{f_{out}} L \right\rceil - n \frac{f_{in}}{f_{out}} L + f_0 \delta_K(n) \right)$$

gegeben ist, wobei $f_0$ zu

$$f_0 = \left( \left\lceil \frac{f_{in}}{f_{out}} L \right\rceil - \frac{f_{in}}{f_{out}} L \right)$$

definiert ist, wobei $\delta_K$ die Kronecker-Delta-Funktion ist, L der Faktor ist, um den das Eingangssignal (x(n)) mit der ersten Abtastrate $f_{in}$ überabgetastet wird, $f_{out}$ die dritte Abtastrate des zweiten Ausgangssignals (v(n)) ist, und die Symbole $\lceil \; \rceil$ und $\lfloor \; \rfloor$ das Runden auf die nächste größere bzw. kleinere ganze Zahl bezeichnen.

**9.** Das Verfahren gemäß einem der Ansprüche 7 oder 8, in dem die dritte Abtastrate zeitabhängig ist, und das Eingangssignal (x(n)) in einem ersten Puffer gespeichert wird und/oder das zweite Ausgangssignal (v(n)) in einem zweiten Puffer gespeichert wird.

**10.** Das Verfahren gemäß Anspruch 9, in dem die dritte Abtastrate einen konstanten Anteil und einen zeitabhängigen Anteil, der durch

$$\Delta f_{out}(n) = \begin{cases} \min\{\Delta f_{out}(n-1) + \Delta, \Delta f_{out,\max}\}, \text{if content of second buffer} \\ \qquad\qquad \text{is below a first predetermined} \\ \qquad\qquad \text{threshold} \\ \\ \max\{\Delta f_{out}(n-1) - \Delta, \Delta f_{out,\min}\}, \text{if content of second buffer} \\ \qquad\qquad \text{is above a second predetermined} \\ \qquad\qquad \text{threshold} \\ \\ \Delta f_{out}(n-1), \text{else} \end{cases}$$

gegeben ist, umfasst, und das zweite Ausgangssignal (v(n)) erhalten wird durch

$$v(n) = \left(1 - \left\lceil \sum_{i=0}^{n} \frac{f_{in}}{f_{out}(i)}L \right\rceil + \sum_{i=0}^{n} \frac{f_{in}}{f_{out}(i)}L - f_0\delta_K(n)\right)y_L\left(\sum_{m=0}^{n} R(m)\right)$$

$$+ \left(\left\lceil \sum_{i=0}^{n} \frac{f_{in}}{f_{out}(i)}L \right\rceil - \sum_{i=0}^{n} \frac{f_{in}}{f_{out}(i)}L + f_0\delta_K(n)\right)y_L\left(\sum_{m=0}^{n} R(m) - 1\right)$$

mit

$$R(n) = \left\lceil \sum_{i=0}^{n} \frac{f_{in}}{f_{out}(i)}L \right\rceil - \sum_{m=0}^{n-1} R(m) + \left\lceil \frac{f_{in}}{f_{out}}L \right\rceil \delta_K(n).$$

11. Das Verfahren gemäß einem der Ansprüche 8 - 10, in dem die erste Abtastrate zeitabhängig ist.

12. Signalverarbeitungsvorrichtung, die dazu ausgebildet ist, aus einem Eingangssignal (x(n)) mit einer ersten Abtastrate ein erstes Ausgangssignal ($v_L$(n)) mit einer zweiten Abtastrate, die von der ersten Abtastrate verschieden ist, durch Ausführen von Verarbeitungsschritten gemäß einem der Ansprüche 1- 6 zu erhalten.

13. Signalverarbeitungsvorrichtung gemäß Anspruch 12, die dazu ausgebildet ist, aus einem Eingangssignal (x(n)) mit einer ersten Abtastrate ein zweites Ausgangssignal (v(n)) mit einer dritten Abtastrate, die von der ersten Abtastrate verschieden ist und/oder von der zweiten Abtastrate verschieden ist, durch Ausführen von Verarbeitungsschritten gemäß einem der Ansprüche 7 - 11 zu erhalten.

14. Elektrische Vorrichtung, insbesondere ein Mobiltelefon oder Headset oder eine Freihandeinrichtung, die die Signalverarbeitungsvorrichtung gemäß einem der Ansprüche 12 oder 13 umfasst.

15. Computerprogrammprodukt, das ein oder mehrere computerlesbare Medien umfasst, die computerausführbare Anweisungen zu Ausführen der Schritte der Verfahren eines der Ansprüche 1 - 11 aufweisen.

**Revendications**

1. Procédé de traitement d'un signal d'entrée (x(n)) d'une première cadence d'échantillonnage, comprenant les étapes suivantes :

   suréchantillonnage (1) du signal d'entrée (x(n)) pour obtenir un signal suréchantillonné ($x_L$(n)) ;
   filtrage passe-bas (2) du signal suréchantillonné ($x_L$(n)) pour obtenir un premier signal suréchantillonné filtré ($y_L$(n)) ;
   retardement (3) du signal suréchantillonné ($x_L$(n)), en particulier, d'un instant d'échantillonnage, et ensuite filtrage passe-bas (4) du signal suréchantillonné retardé ($x_L$(n-1)) pour obtenir un second signal suréchantillonné filtré ($y_L$(n-1)) ;
   pondération du premier signal suréchantillonné filtré ($y_L$(n)) par un premier facteur de pondération pour obtenir un premier signal pondéré ;
   pondération du second signal suréchantillonné filtré ($y_L$(n-1)) par un second facteur de pondération différent du premier facteur de pondération pour obtenir un second signal pondéré ; et
   addition du premier signal pondéré et du second signal pondéré pour obtenir un premier signal de sortie ($v_L$(n)) d'une deuxième cadence d'échantillonnage différente de la première cadence d'échantillonnage.

2. Le procédé selon la revendication 1, dans lequel le filtrage passe-bas (2, 4) du signal suréchantillonné ($x_L$(n)) et du signal suréchantillonné retardé ($x_L$(n-1)) est effectué au moyen d'un filtre à réponse impulsionnelle finie.

3. Le procédé selon la revendication 1 ou 2, dans lequel le signal suréchantillonné retardé ($x_L$(n-1)) est retardé d'un instant d'échantillonnage par rapport au signal suréchantillonné non retardé ($x_L$(n)) et le filtrage passe-bas (4) du signal suréchantillonné retardé ($x_L$(n-1)) est réalisé en utilisant la même réponse impulsionnelle mais retardée d'un instant d'échantillonnage que celle utilisée pour le filtrage passe-bas (2) du signal suréchantillonné non retardé ($x_L$(n)).

4. Le procédé selon l'une des revendications précédentes, dans lequel les premier et second facteurs de pondération sont dépendants du temps ou sont constants et la valeur du second facteur de pondération est donnée par 1 moins la valeur du premier facteur de pondération.

5. Le procédé selon l'une des revendications 2 à 4, dans lequel le signal suréchantillonné ($x_L$(n)) est obtenu en insérant les valeurs nulles L - 1 entre les échantillons individuels du signal d'entrée de la première cadence d'échantillonnage, où L est le facteur au moyen duquel le signal d'entrée (x(n)) est suréchantillonné, et le premier signal suréchantillonné filtré ($y_L$(n)) est obtenu par la convolution modifiée du signal d'entrée (x(n)) avec la réponse impulsionnelle ($h_{TP}$,) du filtre à réponse impulsionnelle finie selon

$$y_L(n) = \sum_{k=0}^{\left\lceil \frac{N}{L} \right\rceil} x\left( \lfloor n/L \rfloor - k \right) h_{TP.kL + \mathrm{mod}(n,L)},$$

où L est le facteur au moyen duquel le signal d'entrée (x(n)) est suréchantillonné et N désigne la longueur de filtre du filtre passe-bas.

6. Le procédé selon la revendication 5, dans lequel le premier signal de sortie ($v_L$(n)) de la deuxième cadence d'échantillonnage est obtenu au moyen des coefficients de filtre dépendants du temps ($\mathbf{h}_{TP}$) utilisés pour le filtrage passe-bas selon

$$v_L(n) = a(n) y_L(n) + (1 - a(n)) y_L(n - 1) = \mathbf{x}^T(n) \mathbf{h}_{TP}(n)$$

avec

$$\mathbf{x}(n) = \begin{bmatrix} x(\lfloor n/L \rfloor) \\ x(\lfloor n/L \rfloor - 1) \\ ... \\ x(\lfloor n/L \rfloor - \lceil N/L \rceil) \end{bmatrix}$$

et

$$\mathbf{h}_{TP}(n) = a(n) \begin{bmatrix} h_{TP,\mathrm{mod}(n,L)} \\ h_{TP,L+\mathrm{mod}(n,L)} \\ \dots \\ h_{TP,L\lceil N/L \rceil + \mathrm{mod}(n,L)} \end{bmatrix} + (1-a(n)) \begin{bmatrix} h_{TP,\mathrm{mod}(n,L)-1} \\ h_{TP,L+\mathrm{mod}(n,L)-1} \\ \dots \\ h_{TP,L\lceil N/L \rceil + \mathrm{mod}(n,L)-1} \end{bmatrix},$$

où a(n) est le premier facteur de pondération et l'indice supérieur T désigne la transposition d'un vecteur ou d'une matrice.

**7.** Le procédé selon l'une des revendications précédentes, où le premier signal de sortie ($v_L(n)$) de la deuxième cadence d'échantillonnage est sous-échantillonné (6) pour obtenir un second signal de sortie (v(n)) d'une troisième cadence d'échantillonnage différente de la deuxième cadence d'échantillonnage.

**8.** Le procédé selon la revendication 7, dans lequel le premier facteur de pondération est donné par

$$a(n) = 1 - \left( \left\lceil n \frac{f_{in}}{f_{out}} L \right\rceil - n \frac{f_{in}}{f_{out}} L + f_0 \delta_K(n) \right)$$

avec $f_0$ défini comme

$$f_0 = \left( \left\lceil \frac{f_{in}}{f_{out}} L \right\rceil - \frac{f_{in}}{f_{out}} L \right),$$

où $\delta_k$ est la fonction Kronecker-Delta, L est le facteur au moyen duquel le signal d'entrée x(n) de la première cadence d'échantillonnage $f_{in}$ est suréchantillonné, $f_{out}$ est la troisième cadence d'échantillonnage du second signal de sortie (v(n)), et les symboles $\lceil \ \rceil$ et $\lfloor \ \rfloor$ désignent l'arrondissement au nombre entier supérieur ou inférieur le plus proche, respectivement.

**9.** Le procédé selon l'une des revendications 7 ou 8, dans lequel la troisième cadence d'échantillonnage est dépendante du temps et le signal d'entrée (x(n)) est stocké dans une première mémoire tampon et/ou le second signal de sortie (v(n)) est stocké dans une seconde mémoire tampon.

**10.** Le procédé selon la revendication 9, dans lequel la troisième cadence d'échantillonnage comprend une contribution constante et une contribution dépendante du temps donnée par

$$\Delta f_{out}(n) = \begin{cases} \min\left\{\Delta f_{out}(n-1) + \Delta, \Delta f_{out,\max}\right\} & \text{si le contenu de la seconde mémoire tampon est inférieur à un premier seuil prédéterminé} \\ \max\left\{\Delta f_{out}(n-1) - \Delta, \Delta f_{out,\min}\right\} & \text{si le contenu de la seconde mémoire tampon est supérieur à un second seuil prédéterminé} \\ \Delta f_{out}(n-1), \textbf{ else} \end{cases}$$

et le second signal de sortie (v(n)) est obtenu par

$$v(n) = \left(1 - \left\lceil \sum_{i=0}^{n} \frac{f_{in}}{f_{out}(i)} L \right\rceil + \sum_{i=0}^{n} \frac{f_{in}}{f_{out}(i)} L - f_0 \delta_K(n)\right) y_L\left(\sum_{m=0}^{n} R(m)\right)$$
$$+ \left(\left\lceil \sum_{i=0}^{n} \frac{f_{in}}{f_{out}(i)} L \right\rceil - \sum_{i=0}^{n} \frac{f_{in}}{f_{out}(i)} L + f_0 \delta_K(n)\right) y_L\left(\sum_{m=0}^{n} R(m) - 1\right)$$

avec

$$R(n) = \left\lceil \sum_{i=0}^{n} \frac{f_{in}}{f_{out}(i)} L \right\rceil - \sum_{m=0}^{n-1} R(m) + \left\lceil \frac{f_{in}}{f_{out}} L \right\rceil \delta_K(n).$$

11. Le procédé selon l'une des revendications 8 à 10, dans lequel la première cadence d'échantillonnage est dépendante du temps.

12. Moyen de traitement de signaux, configuré pour produire à partir d'un signal d'entrée (x(n)) d'une première cadence d'échantillonnage un premier signal de sortie ($v_L$(n)) d'une deuxième cadence d'échantillonnage qui est différente de la première cadence d'échantillonnage en exécutant les étapes de traitement selon l'une des revendications 1 à 6.

13. Moyen de traitement de signaux selon la revendication 12, configuré pour produire à partir d'un signal d'entrée (x(n)) d'une première cadence d'échantillonnage un second signal de sortie (v(n)) d'une troisième cadence d'échantillonnage qui est différente de la première cadence d'échantillonnage et/ou différente de la deuxième cadence d'échantillonnage en exécutant les étapes de traitement selon l'une des revendications 7 à 11.

14. Dispositif électrique, en particulier un téléphone portable, un combiné téléphonique ou un téléphone mains libres, comprenant le moyen de traitement de signaux selon l'une des revendications 12 ou 13.

15. Produit de programme informatique comprenant un ou plusieurs supports lisibles par ordinateur possédant des instructions exécutables par ordinateur permettant d'exécuter les étapes des procédés de l'une des revendications 1 à 11.

FIG. 1

x(n) → ↑L (1) → $x_L(n)$ → $h_{TP,i}$ (2) → $y_L(n)$ → ⊗ a(n)

$z^{-1}$ (3) → $x_L(n-1)$ → $h_{TP,i}$ (4) → $y_L(n-1)$ → ⊗ 1-a(n)

⊕ → $v_L(n)$ → ↓R(n) (6) → v(n)

Control (5)

EP 1 811 663 B1

FIG. 2

FIG. 3

**EP 1 811 663 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6711214 B1
- EP 1569335 A